Europäisches Patentamt

European Patent Office

Office européen des brevets

(11) Publication number: **0 323 673**
**A1**

## (12) EUROPEAN PATENT APPLICATION

(21) Application number: 88203011.7

(22) Date of filing: 23.12.88

(51) Int. Cl.⁴: **B26F 1/44** , **B21D 28/18** , **H05K 3/20** , **H05K 3/04**

(30) Priority: 29.12.87 NL 8703153
29.12.87 NL 8703154

(43) Date of publication of application:
**12.07.89 Bulletin 89/28**

(84) Designated Contracting States:
**AT BE CH DE ES FR GB GR IT LI LU NL SE**

(71) Applicant: **WALKER SCIENTIFIC EUROPE B.V.**
**Industrieweg 9**
**NL-5531 AD Bladel(NL)**

(72) Inventor: **Bijl, Roy**
**Hobbel 8**
**NL-5561 TM Riethoven(NL)**

(74) Representative: **de Vries, Johannes Hendrik**
**Fokke et al**
**Octrooibureau Los en Stigter B.V. P.O. Box**
**20052**
**NL-1000 HB Amsterdam(NL)**

(54) **Apparatus and method for punching a foil or such sheet-like material.**

(57) An apparatus for punching a foil (5) comprises a cutting die (1) having at least a cutting edge (4), and a punching die (6) which is adapted to be introduced partially into the cutting die (1) by a rectilinear movement between punching and cutting dies in order to cut the foil (5) in the form of the cutting edge(s) (4) of the cutting die (1). The part of the punching die (6) cooperating with the cutting die (1) consists of a substantially permanently deformable material.

The invention further includes a method of punching a foil (5) by using this apparatus.

A special application of said method is in the manufacture of a printed circuit on a carrier, wherein a foil (5) is cut in the form of the required circuit pattern, whereupon the cut foil parts pressed into the cutting recesses (3) in the cutting die (1) are urged out of the cutting die (1) and on to the carrier (15) to which they are fixed.

fig.2

## Apparatus and method for punching a foil or such sheet-like material

The invention relates to an apparatus for punching a foil or such sheet-like material, comprising a cutting die having at least one cutting edge, and a punching die adapted to be introduced partially into the cutting die by a rectilinear movement between the cutting and punching dies in order to cut the foil or such sheet-like material in the shape of the cutting edge(s) of the cutting die.

A number of such punching apparatus are well known in the prior art.

In a first known embodiment of such a punching apparatus the punching and cutting dies have complementary shaped stiff surfaces so that the punching and cutting dies comprise co-operating cutting edges.

This known punching apparatus has the disadvantage that both the punching die and the cutting die have to be made very precise and have to be adapted well to each other in order to obtain a clearance required for a proper cutting action between the cutting edges.

Furthermore the guiding of the movement of the punching die should meet very high requirements to obtain a proper cooperation between the punching die and the cutting die.

Another known punching apparatus comprises a cutting die provided with a very hard smooth cutting face on which the foil can be stretched, while the punching die consists of a knife having the contours to be formed. The foil is cut by pressing the knife against the face of the cutting die with the foil therebetween.

Said punching apparatus has a restricted applicability since large discontinuities of the punching die configuration are not permitted. Another disadvantage is the inaccuracy as a consequence of the manual production.

Furthermore, the knife can not be grinded again so that the operational live thereof is limited.

In another known apparatus the punching die is constructed as an elastic bed of rubber on which the foil can be stretched. The cutting die has a plain surface with cutting edges and is able to be pressed onto the foil stretched on the elastic bed, whereby the bed deformes elasticaly and the foil is cut at the cutting edges.

A drawback of this known punching apparatus is that very high demands should be made upon the sharpness of the cutting edges of the cutting die to obtain a proper cutting action. As a consequence, the cutting die is very sensitive to wear. Furthermore, the punching apparatus is only applicable with a very small number of islands (protruding parts) on the cutting die, since otherwise the foil would be exposed to an inadmissible large tensile stress at the cutting recesses between the islands as a consequence of the bulging of the elastic bed into the cutting recesses. This large tensile stress could lead to the formation of cracks in the foil, whereby the foil material at the location of the cutting recesses can not be used as product but should be thrown away as refuse.

It is an object of the invention to provide a punching apparatus wherein the disadvantages described above are removed.

For this purpose, the punching apparatus according to the invention is characterized in that the part of the punching die that cooperates with the cutting die consists of a substantially permanently deformable material.

The substantially permanently deformable material of the punching die will be deformed by shearing at the location of the cutting edges when it is loaded by the cutting die, thereby causing the foil te be cut by pure shearing without being exposed to inadmissible large stretches at other places. The substantially permanently deformable material at the location of the cutting recesses is so to say pressed in each cutting recess as a piston with a flat head carrying along a cut foil part.

It is noted that a punching die including a substantially permanently deformable material is known perse from US-A-2,366,487. However, the punching apparatus disclosed therein consists of a pair of pressure rollers in the pinch of which the assembly of cutting die, work piece and deformable material as punching die is introduced by rotating the pressure rollers. As a result, there is developed an asymmetrical cutting load on the work piece and an asymmetrical deformation of the plastical material at the location of a cutting recess so that not all cutting edges cut at the same time. This apparatus is therefore unsuited for application in cutting thinner foils since these can easily tear as a concequence of the asymmetrical cutting load. If this apparatus having pressure rollers would be used for punching foils there would be a risk of a displacement of the foil and a positioning inaccuracy of the foil resulting herefrom. The apparatus according to US-A-2,366,487 is only suited for punching a metal sheet and not for punching a foil. In the patent specification there is no suggestion at all in this direction. On the contrary, the patent discloses examples of work pieces having a substantial thickness and strength.

Preferably, the substantially permanently deformable material consists of a plastically deformable material.

Plastically deformable material has such a behaviour that at the moment when the shear stress components exceed a limid value in a certain point of the material, an unlimited deformation is possible without appreciable increase of the shear stress components (flow behaviour). As a result, the effective cutting edge angle will actually amount to 90° in the case of a rectangular cutting edge so that a pure shearing of the foil is effected.

Furthermore, there will hardly be any or no deformation when the shear stress components do not exceed a certain limit value. This is particularly favourable for preventing bulging of the material in the cutting recesses. As a consequence the risk for the foil to be teared at the cutting recesses is almost completely avoided so that both the foil material under the islands and the foil material at the cutting recesses can be used as product.

It is an advantage if the plastically deformable material is an anisotropic material.

This anisotropic behaviour promotes shearing of the plastically deformable material at the cutting edges. Because upon deformation of the material the resistance to deformation will be different in different directions so that the anisotripic behaviour can be chosen such that the resistance to deformation is substantially smaller in the direction of punching than in the direction perpendicularly thereto. As a result the flow material, upon deformation of the anisotropic material, will take place mainly in the direction of punching whereby the shearing will be promoted.

A simple embodiment of the punching apparatus according to the invention is characterized in that the punching die comprises a support having a substantially stiff supporting face to which the substantially permanently deformable material, preferable in the form of a layer or sheet, is abieted during the punching operation.

Herein it is very favourable if the cutting die has at least one cutting recess defined by the cutting edges, the supporting face of the support of the punching die comprises at least one elevation arranged oppositely to the corresponding cutting recess in the cutting die, the circumferential configuration of the elevation substantially corresponds to that of the corresponding cutting recess in the cutting die.

As a consequence of this measurement the (plastical) deformation process as described only takes place locally at the cutting edges of the cutting recesses so that the required pressing or punching force decreases substantially if the deformable material remains te same. This enables the use of more rigid deformable materials such as for instance plastically deformable metals as cutting material thereby improving the cutting process. This also reduces the transport of deformable material perpendicular to the direction of punching, whereby the flow profile of the deformable material in the cutting recess is not only symmetrically but also substantially continuous across the width of the cutting recess. Herewith the "shearing effect" in cutting the foil is optimized while maintaining the working of a "hold-down means" for the foil at the cutting edge.

As an alternative, the supporting surface may comprise a profile, preferably consisting of a ribbed profile.

This profile of the supporting surface supporting the layer of permanently deformable material promotes to a lower degree the pure shearing of this material, because it is able to flow away in the direction of punching between the ribs of the profile so that the flow of material perpendicular tot the direction of punching is reduced.

As example for the plastics materials to be used as substantially permanently deformable material poly-ethylene and poly-amide reinforced with glass fibres can be mentioned. With the former material the anisotropic behaviour can be produced by plastic strain and therefore work-hardening in one or more directions. With the latter material the anisotropic behaviour thereof can be effected by means of the orientation of the glass fibres in one direction.

Of course the materials as mentioned are not purely plastic but the plastic behaviour dominates the elastic one by a large degree with substantial deformations whereby the adverse effects of elastic behaviour of the material, such as appears with rubber, disturbs hardly. The substantially permanently deformable plastics materials as mentioned are particularly suited for use in punching plastics foils and thin sheets.

The invention further comprises a method of punching a foil or such sheet-like material, preferably by using the apparatus as discribed herein above, wherein the foil or such sheet-like material is arranged between a cutting die having a cutting recess and a punching die comprising a substantially permanently deformable material, the cutting die and the punching die then being moved rectilinear to each other and being pushed against each other such that the substantially permanently deformable material is urged into the cutting recess of the cutting die by deformation thereby cutting and carrying along the foil or such sheet-like material at the location of the cutting recess.

An important application of this method is in manufacturing a printed circuit on a layer.

In the present practice the printed circuit is made by means of the etching method. Herein, first of all, a drawing of the circuit is made on an enlarged scale on shrink-free paper, which is reduced in a fotographic manner. By means of the negative thus obtained a substance insensitive to the etching bath is applied on a conducting layer, for example copper, provided on the carrier on those places where the conducting tracks of the circuit are required, by means of an exposure process. Then the uncovered copper is chemically removed in the etching bath whereupon the required pattern of the circuit remains on the carrier.

This known method has a number of important disadvantages. First of all, the chemicals used in the method place heavy burdens on the environment. Furthermore the etching method includes a large number of process steps taking a lot of time and occupying a lot of space, since large number of different chemical baths should be passed. There are also substantial amounts of expensive materials wasted. Finally, the accuracy of the final product is limited as a consequence of deformation caused by thermal and other influences. For instance the fotographic foil for the exposure process is very sensitive to moisture whereby shrinkage and expansion can easily appear causing relatively large absolute deviations.

According to the invention a foil of such sheet-like material is cut in the form of the required circuit pattern by means of the punching method as described, whereafter the foil parts urged into the cutting cavities in the cutting die are urged out of the cutting die and onto the carrier to which it is fixed.

Due to this method the environment is unburdened since no etching chemicals are required anymore. Further, substantial time and space savings are obtained with this method, since the numeral etching steps and the chemical baths required therefor can be omitted also no expensive material is wasted anymore. Then only the printed material is used. Any refuse material can be directly utilized again or can easily be recycled. Finally, the accuracy of the printed circuit is only determined by the accuracy of the tools for forming the pattern. Due to the present precise manufacturing techniques this tool can be produced in a very accurate way, while this accuracy can be maintained en can be transfered to the final product in a simple way.

It is advantageously if the cut foil parts in the shape of the required circuit pattern are fixed to the carrier by adhering, wherein it is favourable when the portions of the cutting die between the cutting cavities are covered with a release agent for adhesive, whereupon the cutting die having the cut foil parts in its cutting cavities is placed against the carrier and the foil parts are urged against the carrier and are fixed by adhering.

In this way there is provided a very simple and reliable fixation of the cut foil parts to the carrier. Of course this method of fixation could also be used independently of the special punching operation.

The invention further comprises an apparatus for making a printed circuit on a carrier of electrically insulating material having a conducting material thereon formed out of a foil in the shape of the required circuit pattern by using the method mentioned herein above, comprising a substantially rigid cutting die having cutting recesses adjacent a cutting surface and being in the form of grooves the contours of which correspond to the contours of the printed circuit, the grooves having means for removing cut foil parts therefrom and for applying them to the carrier; and a punching die including a layer of substantially permanently deformable material, and a support having a substantially rigid supporting face for pressing the substantially permanently deformable material into the grooves of the cutting die during the punching operation.

This apparatus has a simple construction and occupies only little space. Furthermore, a very high accuracy can be obtained with this apparatus since the accuracy of the circuit pattern is only determined by the accuracy of the cutting die. Herein, it is for example possible to form the cutting cavities, preferably consisting of grooves, by means of an energy beam treatment, such as a special puls-laser milling method. With this milling method the pulsating laser beam for forming the grooves causes the material of the cutting die to evaporate directly, so that inaccuracies as a consequence of back flow of material in liquid form is prevented, thereby permitting to form very sharp cutting edges. In a similar way it is possible to mill with an electron beam.

The accuracy of the punching operation is only determined by the behaviour of the deformable material of the cutting die. Due to the use of a plastically deformable material the penetration of the portions of the cutting die lying between the cutting cavities into the layer of deformable material is attended by an almost pure shearing of the deformable material in the direction of movement of the cutting die or die punching the respectively thereby cutting the metal foil by shearing without further deformation.

The invention further includes printed circuit boards having a carrier of electrically insulating material and a circuit pattern provided thereon, the printed circuit boards being manufactured by using the method described herein before. Herewith it is possible that the circuit tracks have a a thickness smaller than 0,2 mm, and preferably smaller than 0,05 mm.

The invention will hereafter be elucidated with reference to the drawing, which shows embodiments of the invention by way of example.

Fig. 1 and 2 are very schematic sections of an apparatus for punching a foil or such sheet-like material according to the invention, wherein situations before and after punching are illustrated.

Fig. 3 is a detail of fig. 2 shown on a enlarged scale, wherein the behaviour of the cutting die of plastically deformable material is illustrated.

Fig. 4 is a section corresponding to fig. 3 of a modified embodiment of the punching apparatus according to the invention.

Fig. 5-9 are very schematic sections of an apparatus for manufacturing a printed circuit on a carrier, wherein five different method steps are illustrated.

Fig. 10 is a section corresponding to fig. 6 showing a modified embodiment on an enlarged scale.

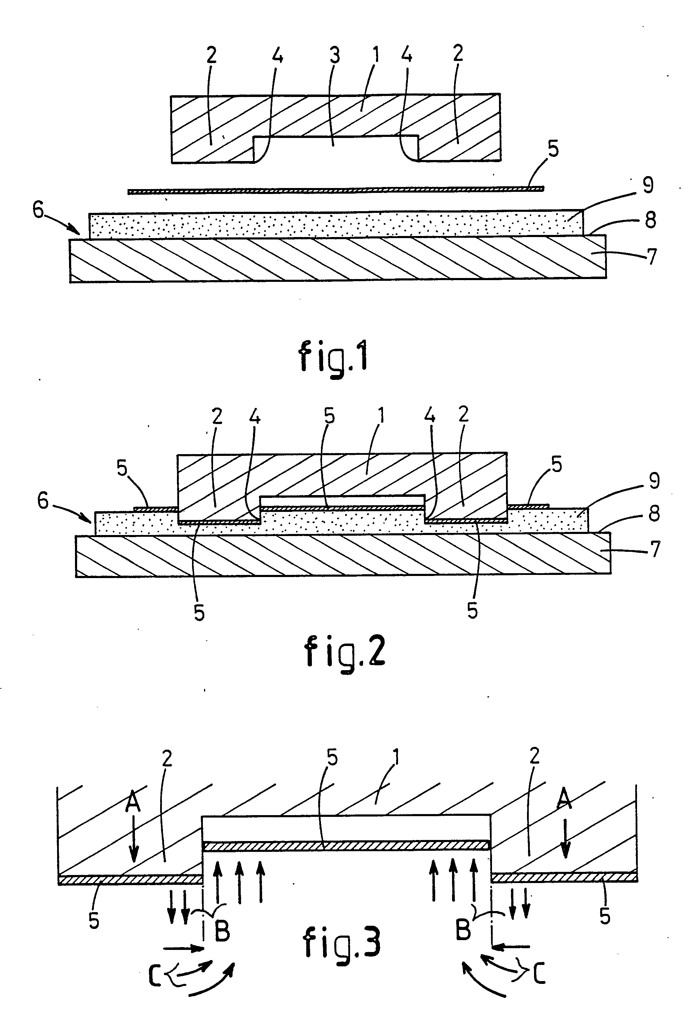

The punching apparatus according to fig. 1 and 2 comprises a cutting die 1 adapted to be displaced rectilinear up and down by means of a drive (not shown). The lower surface of the cutting die 1, which in principal can be regarded as undeformable, has projecting cutting islands 2 interrupted by cutting recesses 3. The contour edges of the cutting islands 2 or cutting recesses 3 respectively are constructed as sharp cutting edges 4. The contours of the cutting islands 2 correspond to the contours of the foil parts to be punched from a foil 5 or such sheet-like material. It is to be understood that foil also includes very thin plate or sheet, such as metal sheet.

For cooperation with the cutting die 1 a punching die 6 is provided consisting of a support 7 having a supporting face 8 on which there is a layer 9 of substantially permanently deformable material. This layer 9 of permanently deformable material forms the operative part of the punching die 6.

Preferably the permanently deformable material is an anisotropic plastical material, for example polyethylene or polyamide reinforced with glass fibres. Also plastically deformable metals, such as brass and aluminium are well usable, in particular in the form of thin sheets. Under tests brass and aluminium sheets having a thickness of 1,0 mm have been used sucessfully. Other thicknesses are possible, however.

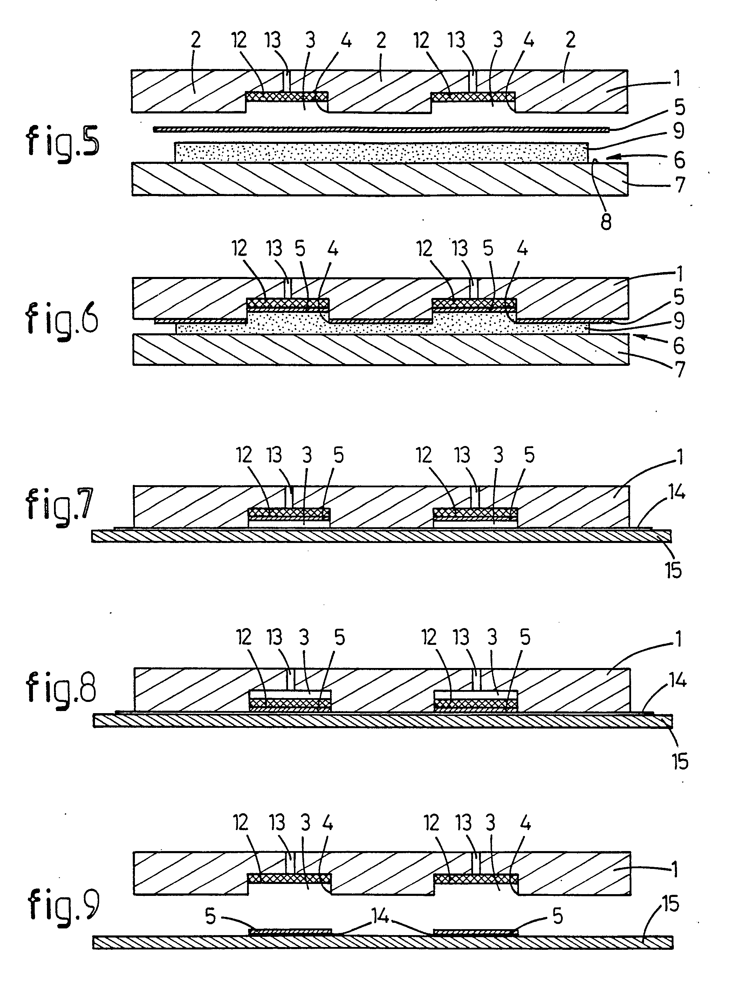

Fig. 3 shows the behaviour of said anisotropic plastical material. When the islands 2 of the punching die 1 is pressed into the layer 9 of anisotropic plastical material (indicated by arrows A) there will be caused a pure shearing in the layer 9 at the location of the cutting edges 4, thereby urging the layer 9 under each cutting recess 3 so to say as a piston having a flat head into the respective cutting recess carrying along the foil part 5 cut by shearing. This shearing operation is illustrated by arrows B. Not until some distance below the cutting edge 4 the flow of material in the layer 9 will be deflected horizontally, such as by arrows C.

In order to geometrically suppress the horizontal flow of material in the layer 9, that is perpendicular to the direction of punching so that a bulging does not appear in the cutting recesses, it is possible to provide the supporting face 8 of the support 7 with a profile, preferably a ribbed profile, so that the material of the layer 9 is permitted to flow away between the ribs of the supporting face 9. .

An apparatus causing a still more favourable shearing of the deformable material at the cutting edges 4 is shown in fig. 4. In this embodiment wherein the punching die 6 is driven, the supporting face 8 of the support 7 of the punching die 6 is provided with flat elevations 10 each belonging to a certain cutting recess 3 in the cutting die 1 and the edges 11 of which having a shape substantially corresponding to the shape of the cutting edges 4 of the respective cutting recess 3. The circumferential dimensions of the elevations 10 may vary between somewhat larger and somewhat smaller then those of the respective cutting recesses 3. A somewhat larger elevation 10 has a favourable effect to the clamping of the deformable material onto the foil along the cutting edge 4. A somewhat smaller elevation 10 is advantageously with respect to the manufacture since in that case the counter mould used in making the cutting die, for example by means of electro-erosive metal removing, may be used as support 7 for the deformable material. As a result the clamping action is only slightly reduced.

According to the invention there is provided a punching apparatus enabling a very accurate punching process in a very simple way without the danger of damaging the foil material to be punched.

Fig. 5-10 show very schematic sections of an apparatus for manufacturing a printed circuit on a carrier, wherein the punching apparatus according to fig. 1-3 is used.

In the apparatus according to fig. 5-9 the cutting recesses 3 in the cutting die 1 are formed as grooves 3. The pattern of the grooves 3 correspond to the pattern of the printed circuit to be made.

The grooves 3 can be made in the cutting die 1 by means of a puls laser milling operation. Herein, material of the cutting die 1 is evaporated by means of a pulsated laser beam. In this way it is possible to form very sharp cutting edges 4 along the islands 2 and the grooves 3.

In the grooves 3 there are ejection means 12 generally extending across the whole area of the grooves 3 and being displaceable between a rest position (fig. 5) in which they are lying completely in their grooves, and an eject position (fig. 9) in which they are displaced in the direction to the opening of the grooves 3.

In the embodiment shown by way of example the ejection means 12 consist of substantially rigid elements being slidable in their respective grooves 3 by means of compressed air supplied from a compressed air supply (not shown) through compressed air apertures 13 opening into the grooves 3 or the cutting die 1 below the ejection means 12.

It is also possible to replace the substantially rigid ejection means by resilient elastic extension elements being connected to the bottom or side walls of the respective grooves and being extendable for example by means of compressed air in order to be displaced from the rest position to the eject position.

The possibility exists to only operate with compressed air, that is without ejection means, whereby the compressed air itself acts as ejection means.

Oppositely the cutting die 1 there is arranged a punching die 6 comprising a rigid support plate 7 and, arranged thereon, a layer 9 of plastically deformable material cooperating with the cutting die 1.

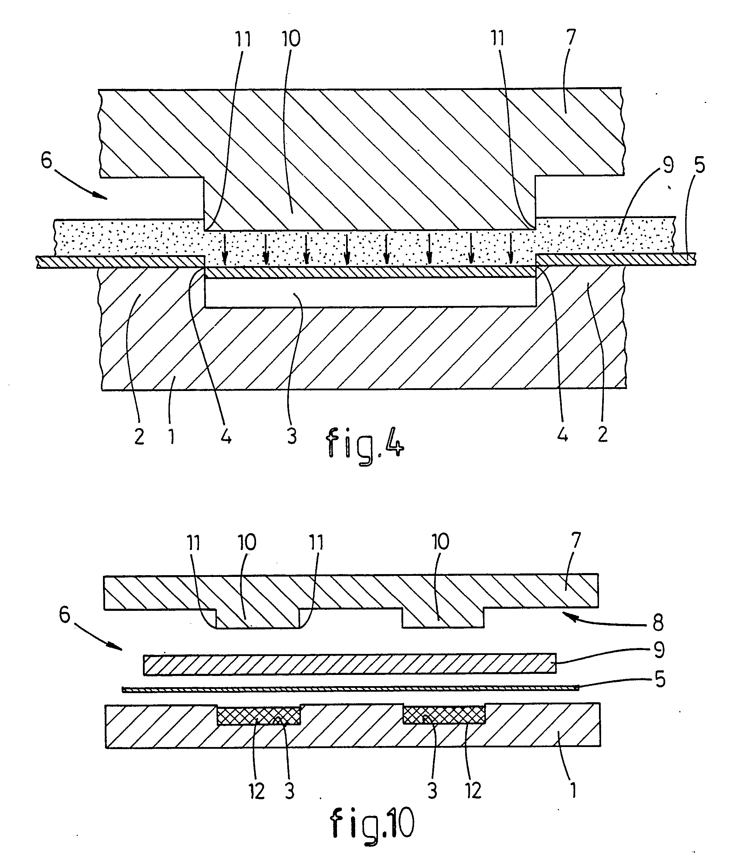

In the embodiment of the apparatus for manufacturing a printed circuit on a carrier as shown in fig. 10, the supporting face 8 of the support 7 of the punching die 6 comprises elavations 10 in the same sense as in fig. 4, the contours of the elevations 10 substantially corresponding to the contours of the grooves 3 in the cutting die 1. Furthermore, the grooves 3 are almost completely filled with elastic material, such as rubber, so that the cut foil parts are urged out of the respective grooves again by the inherent resiliency of the elastic material. Advantageously, a sheet of steel has been used as plastically deformable layer 9. Steel has good cutting properties and is of course cheap.

The method to be carried out with the apparatus comprises punching a conducting sheet-like material, such as a metal foil 5, in the shape of the printed circuit and applying the metal foil 5 on to a carrier 15 of insulating material by means of an adhesive 14.

The method will now be elucidated with reference to fig. 5-9.

In fig. 5 it is shown that the metal foil 5 is cut in the shape of the printed circuit as a result of the cooperation of the punching die 6 and the cutting die 1. Herein, the punching die 6 and the cutting die 1 have been moved to each other so that first of all the metal foil 5 is clamped between the surface of the cutting die 1 and the surface of the layer or sheet 9 of deformable material, whereupon the layer 9 of deformable material penetrates locally into the grooves 3 of the cutting die 1 thereby cutting the metal foil 5. Due to the plastic behaviour of the material of the layer 9 a pure shearing of the material of the layer 9 will be effected at the location of the cutting edges 4 of the cutting die 1 thereby effecting a very sharp accurate cut in the foil 5 lying therebetween.

The cut parts of the foil 5 are pushed into the several grooves 3 in the cutting die 1 together with the plastically deformable material of the layer 9, the cut parts of the foil 5 will remain in the grooves 3 when the punching die 6 and the cutting die 1 are seperated from each other.

In fig. 7, the punching die 6 and the foil parts which can not be used are removed and the carrier 15 to be provided with the printed circuit is arranged under the cutting die 1. Onto the carrier 15 there is applied an adhesive layer 14 for example consisting of a two-component adhesive. This two-component adhesive can be of the type that becomes operative through pressure so that when the metal foil 5 is pressed onto the carrier 15 by means of the ejection means 12 a bond will be formed between the metal foil 5 and the carrier 15. Herein, the islands 2 of the cutting die 1 may be covered with an adhesive releave agent in order to prevent the carrier 14 from adhering to the cutting die 1.

In the situation according to fig. 7 compressed air is supplied to the grooves 3 through the compressed air orifices 13 so that a pressure is exerted to the ejection means 12. As a result thereof, the ejection means 12 will be moved form their rest position according to fig. 7 in the direction to the opening of the grooves 3 to their eject position thereby carrying the metal foil parts 5 along.

In fig. 8, the ejection means 12 have reached their eject position whereby the metal foil parts 5 are pressed onto the carrier 15 lying against the surface of the cutting die 1. By means of the adhesive 14 between the carrier 15 and the metal foil parts 5 a bonding takes place therebetween.

As is visible in fig. 9, the ejection means 12 are then returned to their rest position and the cutting die 1 and the carrier 15 are seperated from each other. The cutting die 1 is then ready again for a next punching action, while the carrier 15 is provided with a printed circuit formed by metal foil parts 5. The carrier 15 having the printed circuit thereon can then be treated further, for example, being assembled with other carriers into a panel consisting of a number of carriers one provided onto the other, or provided with electric components. With the method according to the invention it it possible to form very thin circuits cut out of foil. In tests circuits have been made from copper foils of 0,2 mm, 0,1 mm, 0,03 mm and 0,012 mm. Thinner foils are possible.

The invention is not restricted to the embodiments shown in the drawing and discribed hereinbefore by way of example, the embodiments being liable to many modifications within the scope of the appended claims.

## Claims

1. Apparatus for punching a foil (5) or such sheet-like material, comprising a cutting die (1) having at least one cutting edge (4), and a punching die (6) adapted to be introduced partially into the cutting die (1) by a rectilinear movement between cutting and punching dies in order to cut the foil (5) or such sheet-like material in the shape of the cutting edge(s) (4) of the cutting die (1), wherein the part of the punching die (6) that cooperates with the cutting die (1) consists of a substantially permanently deformable material.

2. Apparatus according to claim 1, wherein the substantially permanently deformable material is a plastically deformable material, preferably an anisotropic material.

3. Apparatus according to one of the preceding claims, wherein the punching die (6) comprises a support (7) having a substantially rigid supporting face (8) to which the substantially permanently deformable material, preferably in the form of a layer or sheet (9), is placed during the punching operation.

4. Apparatus according to claim 3, wherein the cutting die (1) has at least one cutting recess defined by the cutting edges (4), the supporting face (8) of the support (7) of the punching die (6) comprises at least one elevation (10) arranged oppositely to the corresponding cutting recess (3) in the cutting die (1), the circumferential configuration of the elevation substantially corresponding to that of the corresponding cutting recess (3) in the cutting die (1).

5. Apparatus according to claim 3, wherein the supporting face (8) has a profile, for example a ribbed profile.

6. Apparatus according to one of the preceding ·claims, wherein the substantially permanently deformable material is a plastic material, for example poly-ethylene or polyamide reinforced with glass fibres, or a plastically deformable metal, such as brass, aluminium or steel.

7. Method of punching a foil or such a sheet-like material, preferably by using the apparatus according to one of the preceding claims, wherein the foil or such sheet-like material is arranged between a cutting die having a cutting recess and a punching die comprising a substantially permanently deformable material, the cutting die and the punching die then being moved rectilinear to each other and being pushed against each other such that the substantially permanently deformable material is urged into the cutting recess of the cutting die by deformation, thereby cutting and carrying along the foil or such sheet-like material at the location of the cutting recess.

8. Use of the method according to claim 7 for manufacturing a printed circuit on a carrier, wherein a foil or such sheet-like material is cut into the shape of the required circuit pattern, whereupon the cut foil parts pressed into the cutting recesses in the cutting die are urged out of the cutting die and on to the carrier to which it is fixed.

9. Method according to claim 8, wherein the cut foil parts in the shape of the required circuit pattern is fixed to the carrier by adhering.

10. Method according to claim 9, wherein the islands of the cutting die between the cutting recesses are covered with an adhesive releave agent, and the carrier being covered with adhesive, whereupon the cutting die with the cut foil parts in its cutting recesses is placed against the carrier and the foil parts are urged against the carrier and are fixed thereto by adhering.

11. Apparatus for manufacturing a printed circuit on to a carrier (15) of an electrically insulating material having a conducting material thereon formed from a foil (5) and having the shape of the required circuit pattern by using the method according to one of claims 8-10, comprising a substantially rigid cutting die (1) having cutting recesses adjacent a cutting surface and being in the form of grooves (3) the contours of which correspond to the contours of the printed circuit, the grooves (3) having means (12) for removing cut foil parts therefrom and for applying them to the carrier (15); and a punching die (6) including a layer (9) of substantially permanently deformable material, and a support (7) having a substantially rigid supporting face (8) for pressing the substantially permanently deformable material into the grooves (3) of the cutting die (1) during the punching operation.

12. Apparatus according to claim 11, wherein the supporting face (8) of the support (7) comprises elevations (10) arranged oppositely to the respective grooves (3) in the cutting die (1) and the contours of which substantially correspond to those of the respective grooves (3) in the cutting die (1).

13. Apparatus according to claim 12, wherein the means for urging the cut foil out of the grooves of the cutting die and on to the carrier comprise ejection means arranged in the grooves of the cutting die and consisting for example of elastically deformable expansion elements or displaceable substantially rigid ejection means, preferably being displaceable by means of compressed air.

14. Printed circuit board having a carrier (15) of electrically insulating material and a circuit pattern provided thereon, manufactured by using the method according to one of claims 8-10.

15. Printed circuit board according to claim 14, wherein the printed circuit has a thickness of less then 0,2 mm and preferably less then 0,05 mm.

fig.1

fig.2

fig.3

fig.5

fig.6

fig.7

fig.8

fig.9

fig.4

fig.10

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | US-A-3 932 253  (P.F. ELARDE) <br> * Column 1, lines 7-13; column 2, line 54 - column 3, line 54; column 4, lines 13-30,46-63; column 5, lines 3-11,31 - column 6, lines 5,24-33; figures 1-4 * | 1-5,7-10 | B 26 F   1/44 <br> B 21 D  28/18 <br> H 05 K   3/20 <br> H 05 K   3/04 |
| Y | | 11-14 | |
| Y | FR-A-2 217 906  (RADIALL) <br> * Page 1, line 39 - page 2, lines 4,16-21; page 3, lines 10-24; page 5, lines 24-30,34-39; figures 1-4 * | 11-14 | |
| X | US-A-3 628 243  (K.-H. PHOL) <br> * Column 1, lines 19-38,56-63; column 2, lines 6-12,22-58; figures 1-3 * | 1-9,12,14 | |
| X | US-A-2 431 393  (A.W. FRANKLIN) <br> * Column 2, line 18 - column 3, lines 12,28-33; figures 1-5 * | 1,3,7-11,14 | |
| X,D | US-A-2 366 487  (C.E. BURGESS) <br> * Page 2, left-hand column, lines 8-24,51-61; figures 1,3-6 * | 1-3,6,7 | TECHNICAL FIELDS SEARCHED (Int. Cl.4) <br><br> B 26 F <br> B 21 D <br> B 26 D <br> H 05 K |

The present search report has been drawn up for all claims

| Place of search | Date of completion of the search | Examiner |
|---|---|---|
| THE HAGUE | 10-03-1989 | HUGGINS J.D. |

EPO FORM 1503 03.82 (P0401)